# FASCICULE DE BREVET EUROPEEN

(11) **EP 2 091 861 B1**
(45) Date de publication et mention de la délivrance du brevet: **15.03.2017**
(21) Numéro de dépôt: 07847092.9
(22) Date de dépôt: 01.11.2007
(51) Int. Cl.: B81C 99/00, G04D 3/00, G04B 13/02

(54) **PROCEDE DE FABRICATION DE PIECES DE MICROMECANIQUE MULTINIVEAUX EN SILICIUM ET PIECES AINSI OBTENUES**
VERFAHREN ZUR HERSTELLUNG VON MIKROMECHANISCHEN TEILEN AUS SILIZIUM MIT MEHREREN EBENEN UND DAMIT ERHALTENE TEILE
FABRICATION OF MULTILEVEL MICROMECHANICAL SILICON COMPONENTS

(30) Priorité: 10.11.2006 EP 06123873
(43) Date de publication de la demande: 26.08.2009
(73) Titulaire: ETA SA Manufacture Horlogère Suisse, 2540 Grenchen (CH)
(72) Inventeur: MARMY, Philippe, 2843 Châtillon (CH); HELFER, Jean-Luc, 2502 Bienne (CH); CONUS, Thierry, 2543 Lengnau (CH)
(74) Mandataire: Goulette, Ludivine
(86) Numéro de dépôt international: PCT/EP2007/061800
(87) Numéro de publication internationale: WO 2008/055844

(56) Documents cités:
- EP-A- 1 674 264
- WO-A-2005/079128
- FR-A1- 2 874 907
- US-A- 5 273 205
- US-A- 5 484 073
- US-A1- 2005 072 189
- US-A1- 2006 037 187

## Description

### Domaine technique

La présente invention a pour objet un procédé de fabrication de pièces de micromécanique en silicium multiniveau et les pièces ainsi obtenues, utilisées notamment dans le domaine de la construction horlogère.

### Arrière-plan technologique

Les techniques actuelles de fabrication de pièces micromécaniques en silicium permettent d'obtenir une verticalité des flans des pièces suffisamment bien maîtrisée pour que ces pièces soient utilisées comme composants de mécanismes horlogers. La fabrication de pièces à plusieurs niveaux à partir d'une unique plaquette de silicium, à l'aide des techniques actuelles, reste toutefois très délicate.

Le document WO 2005/079128 décrit un système d'empilage automatique de roues solidaires de cadres, chaque cadre étant sélectivement déplacé par un actionneur électrostatique jusqu'à être ajusté dans l'évidement d'un substrat afin d'empiler précisément des roues de plusieurs cadres les unes sur les autres.

Le document FR 2 874 907 décrit un actionneur électrostatique destiné à remplacer les moteurs horlogers du type Lavet pour limiter le nombre de pièces nécessaires au fonctionnement d'une pièce d'horlogerie. L'actionneur électrostatique du type peigne est formé par gravure dans une plaquette en matériau semi-conducteur puis est fixé en porte-à-faux sur un support pour son intégration dans un mouvement.

Le document US 5,273,205 décrit une technique dite « silicon fusion bonding » destinée à attacher deux substrats de silicium entre eux en évitant que des interstices restent entre les deux substrats pour former des capteurs de pression ou des accéléromètres de meilleure qualité.

Une méthode de production alternative de pièces multiniveaux est proposée ici. Cette méthode décrit comment obtenir des pièces silicium multiniveaux uniquement à partir de pièces silicium à un seul niveau produites à l'aide des méthodes actuelles.

### Résumé de l'invention

La présente invention vise donc à apporter une solution simple et économique à la fabrication de pièces de micromécanique multiniveaux à partir de plaquettes en silicium du commerce, lesdites pièces étant utilisées notamment dans la construction d'un mouvement horloger, qu'elles soient fixes ou mobiles.

A cet effet, l'invention concerne un procédé consistant à :
a) usiner dans une première plaquette de silicium par des moyens chimiques, physiques ou combinant les deux, un premier élément ou une pluralité desdits premiers éléments sur la même plaquette;
b) répéter l'étape a) avec une deuxième plaquette de silicium pour usiner un deuxième élément, de forme différente de celle du premier élément, ou une pluralité desdits deuxièmes éléments sur la même plaquette.

Ces procédés permettent de structurer avec précision chaque élément de la pièce finale à obtenir, avec des techniques ayant déjà fait leurs preuves pour des plaquettes ayant des épaisseurs inférieures à 1 mm.

Dans ces procédés divers moyens de positionnement sont possibles pour assurer un positionnement précis des deux éléments devant constituer la pièce finale avant d'effectuer une oxydation thermique pour lier physiquement les deux éléments entre eux. Dans la description détaillée qui suit, deux exemples de moyens de positionnement sont donnés faisant appel, soit à des moyens de repérage formés dans chaque plaquette en même temps que la structuration des éléments qui seront alors liés entre eux par des ponts de matière, soit à l'utilisation d'un gabarit permettant de positionner les plaquettes l'une sur l'autre ou des éléments détachés de celles-ci.

L'étape d'oxydation de l'interface entre les plaquettes peut être effectuée par voie sèche avec de l'oxygène sec, ou par voie humide avec de la vapeur d'eau, par exemple dans un four chauffé à une température comprise entre 900°C et 1200°C selon des techniques bien connues de l'homme de l'art rapportées par exemple dans l'ouvrage "Semiconductors devices : physics and technology - éditions John Wiley & Sons, ISBN 0-471-874-8-01.01.1985 p. 341-355".

Cette oxydation peut également être effectuée par tout autre moyen connu de l'homme de l'art, par exemple par la technique d'oxydation amplifiée par laser.

Il est également possible d'obtenir une pièce ayant plus de deux niveaux en usinant une troisième plaquette de silicium pouvant être intégrée dans les procédés de l'invention.

Le procédé selon l'invention permet de fabriquer facilement des pièces de micromécaniques multiniveaux en silicium, tels que des paliers, des platines ou des ponts alvéolés, des mobiles de réduction pour un mouvement horloger, etc ...

### Brèves description des dessins

D'autres caractéristiques et avantages de la présente invention apparaîtront plus clairement dans la description qui suit d'exemples de réalisation, donnés à titre illustratif et non limitatif, en référence aux dessins annexés dans lesquels:
- la figure 1 est une représentation schématique des étapes du procédé permettant d'obtenir un palier avec pierre à trou et pierre contre-pivot;
- la figure 2 représente un autre palier pouvant être obtenu par le procédé, et
- la figure 3 représente un mobile réducteur pouvant être obtenu par le procédé.

### Description détaillée de l'invention

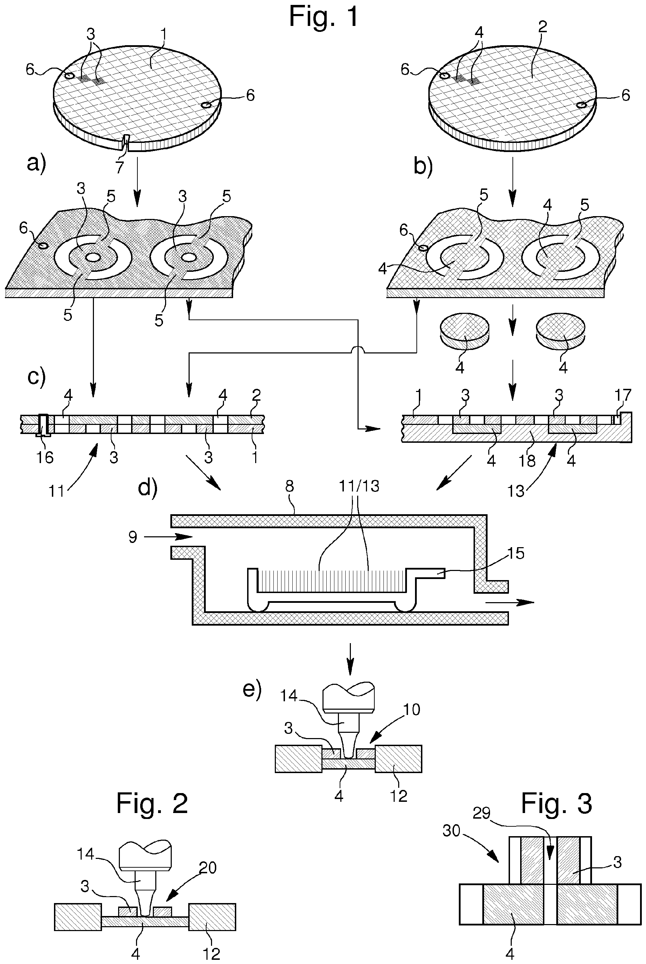

La figure 1 est une représentation schématique des étapes du procédé permettant d'obtenir un palier 10 en silicium dont un premier élément 3 forme la "pierre à trou" et dont un deuxième élément 4 forme la "pierre contre-pivot". Typiquement ces pierres ont des dimensions comprises entre 0,12 et 0,35 mm pour l'épaisseur et entre 0,70 et 1,80 mm pour le diamètre.

Dans une première étape a) on usine dans une première plaquette de silicium 1, le premier élément 3 mais de préférence une pluralité desdits premiers éléments 3. En effet en partant d'une plaquette de silicium du commerce, dont le diamètre peut varier de 75 mm à environ 300 mm, il est possible de structurer une pluralité d'éléments ayant un diamètre inférieur à 2 mm. Une telle plaquette a généralement une épaisseur inférieure à 1 mm, ce qui est compatible avec les dimensions horlogères, mais cette épaisseur peut être amenée à la cote précise désirée par attaque chimique. De préférence on fera en sorte qu'une face de la plaquette ne soit pas polie, qu'elle soit disponible comme telle dans le commerce, ou qu'on lui fasse subir un léger traitement abrasif.

La structuration des éléments 3 dans la plaquette 1 est effectuée par des méthodes connues de l'homme de l'art par photolithographie et attaque à travers le masque formé. Cette attaque peut être effectuée selon divers procédés également connus dans le domaine de l'usinage du silicium. Le procédé permettant d'avoir le meilleur rapport d'aspect, c'est-à-dire des flancs de découpe perpendiculaires à la surface de la pièce, est la technique RIE (Reactive Ion Ectching).

Cette technique, et les adaptations nécessaires à chaque cas particulier, étant bien connues de l'homme de l'art, ne sera donc pas décrite plus avant.

Dans cette première étape, des ponts de matière 5 sont prévus pour maintenir les éléments 3 liés à leur plaquette support 1. Cette structuration permet également de former dans la plaquette 1 des éléments de positionnement de ladite plaquette 1 par rapport à la plaquette 2. A titre d'exemple ces moyens de positionnement sont constitués par deux perçages 6, la référence 7 désignant d'autres moyens de positionnement qui seront expliqués plus loin.

Il est bien évident que les ponts de matière 5 entre les éléments de chaque plaquette ne sont pas forcément nécessaire selon le mode de positionnement utilisé.

Dans l'étape b), on reproduit le même processus que celui de l'étape a) à partir d'une deuxième plaquette 2 pour conformer les deuxièmes éléments 4, à savoir la "pierre contre-pivot", ainsi que des moyens de positionnement 6 qui coïncident avec les moyens de positionnement 6 de la première plaquette. Dans cet exemple les éléments 3 et 4 ont le même diamètre.

Lorsque les plaquettes 1 et 2 utilisées dans les étapes a) et b) ont au moins une face non polie, leur assemblage peut être effectué sans traitement de surface préalable en appliquant les faces non polies l'une contre l'autre. Si les deux faces de chaque plaquette sont polies on effectuera de préférence un traitement de surface préalable permettant de rendre les faces devant être appliquées l'une contre l'autre, soit légèrement rugueuses, soit revêtues d'un film d'oxyde de silicium un peu plus épais que l'oxyde natif.

L'étape c), telle que représentée dans la partie gauche du schéma, consiste à positionner des deux plaquettes 1, 2 l'une sur l'autre et à fixer cette position par exemple au moyen de chevilles 16 pour former un assemblage 11.

La partie droite du schéma illustre un deuxième exemple de positionnement. Les deuxièmes éléments 4 sont d'abord détachés de la deuxième plaquette 2 en brisant les ponts de matière 5, ou obtenus ainsi sans pont de matière 5, puis positionnés dans des alvéoles correspondantes d'un gabarit 18 en quartz. On vient ensuite appliquer la première plaquette 1 en la positionnant grâce à une fente 7 usinée dans son bord, ladite fente 7 venant s'engager dans un ergot 17 du gabarit 18 pour former un assemblage 13. En utilisant un gabarit 18 comportant des alvéoles ayant la profondeur appropriée on peut également avoir les premiers éléments 3 séparés de la première plaquette 1 pour les placer dans le gabarit 18.

Dans l'étape d) on place une série d'assemblages 11 ou 13 sur un chariot 15 qu'on introduit dans un four 8 porté à une température comprise entre 900° C et 1200° C et dans lequel on fait circuler un mélange oxydant 9 pendant environ 2 à 4 heures. Cette étape d'oxydation, qui va lier les deux plaquettes 1, 2 par des liaisons de type siloxane peut-être effectuée, soit par voie sèche avec un mélange comprenant un gaz porteur inerte et de l'oxygène sec, soit par voie humide en remplaçant l'oxygène par de la vapeur d'eau.

A l'issue de cette étape, on sort le chariot 15 du four 8, on laisse les assemblages 11 ou 13 revenir à température ambiante, puis on sépare les pièces 10 ainsi formées en brisant les ponts de matière 5 résiduels. Le palier 10 ainsi obtenu est alors prêt à être utilisé en le montant dans un chaton 12, pour recevoir un pivot 14 d'un mobile de mouvement d'horlogerie.

La figure 2 représente une variante de réalisation dans laquelle les pierres 3, 4 du palier 20 n'ont pas le même diamètre. Dans ce cas on utilisera de préférence la variante de procédé faisant appel à un gabarit 18, ledit gabarit pouvant avantageusement être formé d'alvéoles multi-étages permettant à la fois d'empiler les éléments 3 et 4 et de les positionner les uns par rapport aux autres.

La figure 3 représente une autre pièce 30 pouvant être obtenue selon le procédé de l'invention. Il s'agit d'un mobile de réduction formé par assemblage dans lequel l'élément 3 est le pignon et l'élément 4 la roue dentée, les deux éléments 3, 4 étant traversés par un trou d'axe 29.

Les exemples qui viennent d'être décrits concernent la fabrication d'une pièce de micromécanique à deux niveaux, mais il est bien évident qu'on pourrait avoir un plus grand nombre de niveaux. Il suffit pour cela de partir de trois plaquettes de silicium ou plus, ou de réitérer le procédé à l'issue de l'étape e).

L'invention n'est pas limitée aux exemples qui viennent d'être décrits et l'homme de métier peut mettre en oeuvre le procédé pour obtenir d'autres pièces de micromécanique.

Elle n'est pas non plus limitée à des pièces de petites dimensions. Le procédé peut avantageusement être mis en oeuvre pour des pièces de plus grandes dimensions telles que des platines ou des ponts d'un mouvement horloger, comportant des noyures. De telles pièces ont des épaisseurs de l'ordre de 2 mm et ne seraient pas réalisables à partir d'une seule plaquette de silicium du commerce.

## Revendications

1. Procédé de fabrication d'au moins une pièce de micromécanique (10, 20, 30) en silicium mono ou polycristallin ayant au moins deux niveaux comportant les étapes consistant à :
- usiner dans une première plaquette de silicium (1) par des moyens chimiques, physiques ou combinant les deux, au moins un premier élément (3) formant un niveau de ladite au moins une pièce de micromécanique ;
- répéter l'étape précédente avec une deuxième plaquette de silicium (2) pour usiner au moins un deuxième élément (4) formant un autre niveau de ladite au moins une pièce de micromécanique, de forme différente de celle dudit au moins un premier élément ;
- appliquer face contre face ledit au moins un premier élément (3) lié à la première plaquette (1) et ledit au moins un deuxième élément (4) lié à la deuxième plaquette (2) à l'aide de moyens de positionnement (6, 7) afin de former au moins un ensemble ;
- effectuer une oxydation afin de lier l'interface entre les première et deuxième plaquettes (1, 2) permettant de fixer ledit au moins un ensemble pour former ladite au moins une pièce de micromécanique ;
- séparer ladite au moins une pièce de micromécanique (10, 20, 30) des première et deuxième plaquettes (1, 2).

2. Procédé selon la revendication précédente, **caractérisé en ce que** les moyens de positionnement (6, 7) sont usinés dans chaque plaquette (1, 2) en même temps que ledit au moins un premier élément (3) et ledit au moins un deuxième élément (4).

3. Procédé selon l'une des revendications précédentes, **caractérisé en ce que** les moyens de positionnement des plaquettes (1, 2) sont constitués par au moins deux trous (6) dans lesquels sont engagés des chevilles de positionnements (16).

4. Procédé selon l'une des revendications précédentes, **caractérisé en ce que** chaque élément est maintenu sur sa plaquette par des ponts de matière (5).

5. Procédé de fabrication d'au moins une pièce de micromécanique (10, 20, 30) en silicium mono ou polycristallin ayant au moins deux niveaux comportant les étapes consistant à :
- usiner dans une première plaquette de silicium (1) par des moyens chimiques, physiques ou combinant les deux, au moins un premier élément (3) formant un niveau de ladite au moins une pièce de micromécanique ;
- répéter l'étape précédente avec une deuxième plaquette de silicium (2) pour usiner au moins un deuxième élément (4) formant un autre niveau de ladite au moins une pièce de micromécanique, de forme différente de celle dudit au moins un premier élément ;
- séparer ledit au moins un premier élément (3) de la première plaquette (1) ;
- positionner ledit au moins un premier élément séparé dans un gabarit (18) ;
- appliquer face contre face ledit au moins un premier élément (3) dans le gabarit (18) audit au moins un deuxième élément lié à la deuxième plaquette (2) à l'aide de moyens de positionnement (6, 7) afin de former au moins un ensemble ;
- effectuer une oxydation afin de lier l'interface entre ledit au moins un premier élément (3) et la deuxième plaquette (2) permettant de fixer ledit au moins un ensemble pour former ladite au moins une pièce de micromécanique ;
- séparer ladite au moins une pièce de micromécanique (10, 20, 30) de la deuxième plaquette (2) et du gabarit (18).

6. Procédé selon la revendication précédente, **caractérisé en ce que** la deuxième plaquette (2) est appliquée dans un logement du gabarit (18), la deuxième plaquette (2) comportant sur son bord au moins une fente (7) venant s'engager dans une nervure correspondante (17) du gabarit (18).

7. Procédé de fabrication d'au moins une pièce de micromécanique (10, 20, 30) en silicium mono ou polycristallin ayant au moins deux niveaux comportant les étapes consistant à :
- usiner dans une première plaquette de silicium (1) par des moyens chimiques, physiques ou combinant les deux, au moins un premier élément (3) formant un niveau de ladite au moins une pièce de micromécanique ;
- répéter l'étape précédente avec une deuxième plaquette de silicium (2) pour usiner au moins un deuxième élément (4) formant un autre niveau de ladite au moins une pièce de micromécanique, de forme différente de celle dudit au moins un premier élément ;
- séparer ledit au moins un premier élément (3) et ledit au moins un deuxième élément (4) des première et deuxième plaquettes (1, 2) ;
- appliquer face contre face ledit au moins un premier élément (3) et ledit au moins un deuxième élément (4) dans un gabarit à deux niveaux afin de former au moins un ensemble ;
- effectuer une oxydation afin de lier l'interface entre ledit au moins un premier élément (3) et ledit au moins un deuxième élément (4) permettant de fixer ledit au moins un ensemble pour former ladite au moins une pièce de micromécanique ;
- séparer ladite au moins une pièce de micromécanique (10, 20, 30) du gabarit à deux niveaux.

8. Procédé selon l'une des revendications précédentes, **caractérisé en ce que** l'étape d'oxydation s'effectue dans un four (8) chauffé à une température comprise entre 900 °C et 1200 °C en présence d'un mélange oxydant (9) pendant environ 2 à 4 heures.

9. Procédé selon l'une des revendications précédentes, **caractérisé en ce que** les faces des éléments (3, 4) devant être appliqués l'un contre l'autre sont préalablement oxydées.

10. Procédé selon l'une des revendications 1 à 8, **caractérisé en ce que** les faces des éléments (3, 4) devant être appliqués l'un contre l'autre subissent un traitement préalable pour leur conférer une certaine rugosité.

11. Procédé selon les revendications précédentes, **caractérisé en ce qu'**il comporte en outre au moins une étape supplémentaire consistant à usiner au moins une troisième plaquette pour former un troisième élément assemblé avec les deux précédents pour former au moins un troisième niveau.

12. Composant d'un mécanisme horloger obtenu par le procédé selon l'une des revendications précédentes, **caractérisé en ce qu'**il comporte une pièce micromécanique (10,20,30) multiniveaux recouverte d'une couche d'oxyde de silicium, la couche d'oxyde de silicium étant formée également à l'interface entre au moins un premier élément (3) en silicium et au moins un deuxième élément (4) en silicium empilés pour les fixer ensemble.

13. Composant selon la revendication 12, **caractérisé en ce que** la couche d'oxydation desdits au moins un premier élément (3) et au moins un deuxième élément (4) comportent des liaisons siloxane.

14. Composant selon la revendication 12 ou 13, **caractérisé en ce qu'**il comporte deux éléments (3, 4) dont le premier est percé pour recevoir un pivot permettant de former le coussinet d'un palier.

15. Composant selon la revendication 12 ou 13, **caractérisé en ce qu'**il comporte deux éléments (3, 4) qui sont percées pour recevoir un axe et qui comportent des dentures sur leur diamètre extérieur permettant de former un mobile de transmission.

16. Composant selon la revendication précédente, **caractérisé en ce que** lesdits deux éléments (3, 4) ont des diamètres extérieurs de grandeurs différentes permettant de former un mobile de réduction.

17. Pièce d'horlogerie **caractérisée en ce qu'**elle incorpore un composant multiniveaux en silicium selon l'une des revendications 12 à 16.

## Patentansprüche

1. Verfahren für die Herstellung mindestens eines mikromechanischen Teils (10, 20, 30) aus monokristallinem oder polykristallinem Silicium mit mindestens zwei Ebenen, das die Schritte umfasst, die darin bestehen:
- in einem ersten Siliciumplättchen (1) durch chemische oder physikalische Mittel oder eine Kombination aus beiden mindestens ein erstes Element (3) zu fertigen, das eine Ebene des mindestens einen mikromechanischen Teils bildet;
- den vorhergehenden Schritt mit einem zweiten Siliciumplättchen (2) zu wiederholen, um mindestens ein zweites Element (4), das eine andere Ebene des mindestens einen mikromechanischen Teils bildet, mit einer Form, die von jener des mindestens einen ersten Elements verschieden ist, zu fertigen;
- das mindestens eine erste Element (3), das mit dem ersten Plättchen (1) verbunden ist, und das mindestens eine zweite Element (4), das mit dem zweiten Plättchen (2) verbunden ist, mit Hilfe von Positionierungsmitteln (6, 7) Fläche auf Fläche aufeinander zu legen, um mindestens eine Baugruppe zu bilden;
- eine Oxidation durchzuführen, um die Grenzfläche zwischen dem ersten und dem zweiten Plättchen (1, 2) zu verbinden, was ermöglicht, die mindestens eine Baugruppe zu fixieren, um das mindestens eine mikromechanische Teil zu bilden;
- das mindestens eine mikromechanische Teil (10, 20, 30) von dem ersten und dem zweiten Plättchen (1, 2) zu trennen.

2. Verfahren nach dem vorhergehenden Anspruch, **dadurch gekennzeichnet, dass** die Positionierungsmittel (6, 7) in jedem Plättchen (1, 2) gleichzeitig mit dem mindestens einen ersten Element (3) und dem mindestens einen zweiten Element (4) gefertigt werden.

3. Verfahren nach einem der vorhergehenden Ansprüche, **dadurch gekennzeichnet, dass** die Mittel zum Positionieren der Plättchen (1, 2) durch mindestens zwei Löcher (6) gebildet sind, in die Positionierungszapfen (16) eingesetzt sind.

4. Verfahren nach einem der vorhergehenden Ansprüche, **dadurch gekennzeichnet, dass** jedes Element auf seinem Plättchen durch Materialbrücken (5) gehalten wird.

5. Verfahren für die Herstellung mindestens eines mikromechanischen Teils (10, 20, 30) aus monokristallinem oder polykristallinem Silicium mit mindestens zwei Ebenen, das die Schritte umfasst, die darin bestehen:
- in einem ersten Siliciumplättchen (1) durch chemische oder physikalische Mittel oder einer Kombination aus beiden mindestens ein erstes Element (3) zu fertigen, das eine Ebene des mindestens einen mikromechanischen Teils bildet;
- den vorhergehenden Schritt mit einem zweiten Siliciumplättchen (2) zu wiederholen, um mindestens ein zweites Element (4), das eine andere Ebene des mindestens einen mikromechanischen Teils bildet, mit einer Form, die von jener des mindestens einen ersten Elements verschieden ist, zu fertigen;
- das mindestens eine erste Element (3) von dem ersten Plättchen (1) zu trennen;
- das mindestens eine getrennte erste Element in einer Schablone (18) zu positionieren;
- das mindestens eine erste Element (3) in der Schablone (18) Fläche an Fläche und das mindestens eine zweite Element, das mit dem zweiten Plättchen (2) verbunden ist, mit Hilfe von Positionierungsmitteln (6, 7) aufeinander zu legen, um mindestens eine Baugruppe zu bilden;
- eine Oxidation durchzuführen, um die Grenzfläche zwischen dem mindestens einen ersten Element (3) und dem zweiten Plättchen (2) zu verbinden, was ermöglicht, die mindestens eine Baugruppe zu fixieren, um das mindestens eine mikromechanische Teil zu bilden;
- das mindestens eine mikromechanische Teil (10, 20, 30) von dem zweiten Plättchen (2) und von der Schablone (18) zu trennen.

6. Verfahren nach dem vorhergehenden Anspruch, **dadurch gekennzeichnet, dass** das zweite Plättchen (2) in einem Aufnahmeraum der Schablone (18) angebracht wird, wobei das zweite Plättchen (2) an seinem Rand mindestens eine Aussparung (7) aufweist, die mit einem entsprechenden Steg (17) der Schablone (18) in Eingriff gelangt.

7. Verfahren für die Herstellung mindestens eines mikromechanischen Teils (10, 20, 30) aus monokristallinem oder polykristallinem Silicium mit mindestens zwei Ebenen, das die Schritte umfasst, die darin bestehen:
- in einem ersten Siliciumplättchen (1) durch chemische oder physikalische Mittel oder eine Kombination von beiden mindestens ein erstes Element (3) zu fertigen, das eine Ebene des mindestens einen mikromechanischen Teils bildet;
- den vorhergehenden Schritt mit einem zweiten Siliciumplättchen (2) zu wiederholen, um mindestens ein zweites Element (4), das eine andere Ebene des mindestens einen mikromechanischen Teils bildet, mit einer Form, die von jener des mindestens einen ersten Elements verschieden ist, zu fertigen;
- das mindestens eine erste Element (3) und das mindestens eine zweite Element (4) von dem ersten und dem zweiten Plättchen (1, 2) zu trennen;
- das mindestens eine erste Element (3) und das mindestens eine zweite Element (4) in einer Schablone mit zwei Niveaus Fläche auf Fläche aufeinander zu legen, um mindestens eine Baugruppe zu bilden;
- eine Oxidation auszuführen, um die Grenzfläche zwischen dem mindestens einen ersten Element (3) und dem mindestens einen zweiten Element (4) zu verbinden, was ermöglicht, die mindestens eine Baugruppe zu fixieren, um das mindestens eine mikromechanische Teil zu bilden;
- das mindestens eine mikromechanische Teil (10, 20, 30) von der Schablone mit zwei Niveaus zu trennen.

8. Verfahren nach einem der vorhergehenden Ansprüche, **dadurch gekennzeichnet, dass** der Oxidationsschritt in einem Ofen (8), der auf eine Temperatur im Bereich von 900 °C bis 1200 °C geheizt ist, in Gegenwart eines oxidierenden Gemisches (9) während etwa 2 bis 4 Stunden erfolgt.

9. Verfahren nach einem der vorhergehenden Ansprüche, **dadurch gekennzeichnet, dass** die aufeinander zu legenden Flächen der Elemente (3, 4) zuvor oxidiert werden.

10. Verfahren nach einem der Ansprüche 1 bis 8, **dadurch gekennzeichnet, dass** die Flächen der aufeinander zu legenden Elemente (3, 4) einer vorausgehenden Bearbeitung unterzogen werden, um ihnen eine bestimmte Rauigkeit zu verleihen.

11. Verfahren nach den vorhergehenden Ansprüchen, **dadurch gekennzeichnet, dass** es außerdem mindestens einen zusätzlichen Schritt umfasst, der darin besteht, mindestens ein drittes Plättchen zu bearbeiten, um ein drittes Element zu bilden, das mit den beiden vorhergehenden Elementen zusammengefügt wird, um mindestens eine dritte Ebene zu bilden.

12. Komponente eines Uhrenmechanismus, die durch das Verfahren nach einem der vorhergehenden Ansprüche erhalten wird, **dadurch gekennzeichnet, dass** sie ein mikromechanisches Teil (10, 20, 30) mit mehreren Ebenen umfasst, das mit einer Siliciumoxidschicht bedeckt ist, wobei die Siliciumoxidschicht außerdem auf der Grenzfläche zwischen mindestens einem ersten Element (3) aus Silicium und mindestens einem zweiten Element (4) aus Silicium, die gestapelt sind, gebildet ist, um sie aneinander zu befestigen.

13. Komponente nach Anspruch 12, **dadurch gekennzeichnet, dass** die Oxidationsschicht des mindestens einen ersten Elements (3) und des mindestens einen zweiten Elements (4) Siloxanverbindungen umfasst.

14. Komponente nach Anspruch 12 oder 13, **dadurch gekennzeichnet, dass** sie zwei Elemente (3, 4) umfasst, wovon das erste durchlocht ist, um einen Drehzapfen aufzunehmen, was ermöglicht, die Lagerbuchse eines Lagers zu bilden.

15. Komponente nach Anspruch 12 oder 13, **dadurch gekennzeichnet, dass** sie zwei Elemente (3, 4) umfasst, die durchlocht sind, um eine Welle aufzunehmen, und die an ihrem Außendurchmesser Zahnungen aufweisen, die ermöglichen, ein Kraftübertragungsdrehteil zu bilden.

16. Komponente nach dem vorhergehenden Anspruch, **dadurch gekennzeichnet, dass** die zwei Elemente (3, 4) Außendurchmesser mit verschiedenen Größen haben, was ermöglicht, ein Untersetzungsdrehteil zu bilden.

17. Zeitmessgerät, **dadurch gekennzeichnet, dass** es eine Komponente mit mehreren Ebenen aus Silicium nach einem der Ansprüche 12 bis 16 umfasst.

## Claims

1. Method for manufacturing at least one mono or polycrystalline silicon micromechanical part (10, 20, 30) having at least two levels, including the steps consisting in:
- machining, in a first silicon wafer (1) by chemical or physical means or a combination of the two, at least one first element (3) forming one level of said at least one micromechanical part;
- repeating the preceding step with a second silicon wafer (2) to machine at least one second element (4) forming another level of said at least one micromechanical part, of different shape from that of said at least one first element;
- placing said at least one first element (3) connected to the first wafer (1) and said at least one second element (4) connected to the second wafer (2) face to face against each other with the aid of positioning means (6, 7) to form at least one assembly;
- performing oxidation to bind the interface between the first and second wafers (1, 2) allowing said at least one assembly to be secured to form said at least one micromechanical part;
- separating said at least one micromechanical part (10, 20, 30) from the first and second wafers (1, 2).

2. Method according to the preceding claim, **characterized in that** the positioning means (6, 7) are machined in each wafer (1, 2) at the same time as said at least one first element (3) and said at least one second element (4).

3. Method according to any of the preceding claims, **characterized in that** the means for positioning the wafers (1, 2) are formed by at least two holes (6) in which positioning pins (16) are engaged.

4. Method according to any of the preceding claims, **characterized in that** each element is held on its wafer by bridges of material (5).

5. Method for manufacturing at least one mono or polycrystalline silicon micromechanical part (10, 20, 30) having at least two levels including the steps consisting in:
- machining, in a first silicon wafer (1) by chemical or physical means or a combination of the two, at least one first element (3) forming one level of said at least one micromechanical part;
- repeating the preceding step with a second silicon wafer (2) to machine at least one second element (4) forming another level of said at least one micromechanical part, of different shape from that of said at least one first element;
- separating said at least one first element (3) from the first wafer (1);
- positioning said at least one first separate element in a template (18);
- placing said at least one first element (3) in the template (18) face to face against said at least one second element connected to the second wafer (2) with the aid of positioning means (6, 7) to form at least one assembly;
- performing oxidation to bind the interface between said at least one first element (3) and the second wafer (2) allowing said at least one assembly to be secured to form said at least one micromechanical part;
- separating said at least one micromechanical part (10, 20, 30) from the second wafer (2) and from the template (18).

6. Method according to the preceding claim, **characterized in that** the second wafer (2) is placed inside a housing of the template (18), the second wafer (2) including on the edge thereof at least one slot (7) that engages in a corresponding rib (17) of the template (18).

7. Method for manufacturing at least one mono or polycrystalline silicon micromechanical part (10, 20, 30) having at least two levels including the steps consisting in:
- machining, in a first silicon wafer (1) by chemical or physical means or a combination of the two, at least one first element (3) forming one level of said at least one micromechanical part;
- repeating the preceding step with a second silicon wafer (2) to machine at least one second element (4) forming another level of said at least one micromechanical part, of different shape from that of said at least one first element;
- separating said at least one first element (3) and said at least one second element (4) from said first and second wafers (1, 2);
- placing said at least one first element (3) and said at least one second element (4) face to face inside a two-level template (18) to form at least one assembly;
- performing oxidation to bind the interface between said at least one first element (3) and said at least one second element (4) allowing said at least one assembly to be secured to form said at least one micromechanical part;
- separating said at least one micromechanical part (10, 20, 30) from the two-level template (18).

8. Method according to any of the preceding claims, **characterized in that** the oxidation step is performed in a furnace (8) heated to a temperature comprised between 900°C and 1200°C in the presence of an oxidising mixture (9) for around 2 to 4 hours.

9. Method according to any of the preceding claims, **characterized in that** the surfaces of the elements (3, 4) required to be placed against each other are previously oxidised.

10. Method according to any of claims 1 to 8, **characterized in that** the surfaces of the elements (3, 4) required to be placed against each other undergo prior treatment giving said surfaces a certain roughness.

11. Method according to the preceding claims, **characterized in that** the method further includes at least one additional step consisting in machining at least a third wafer to form a third element assembled with the two preceding elements to form at least a third level.

12. Component of a timepiece mechanism obtained by the method according to any of the preceding claims, **characterized in that** the component includes a multi-level micromechanical part (10, 20, 30) coated with a silicon oxide layer, the silicon oxide layer also being formed at the interface between at least one first silicon element (3) and at least one second silicon element (4), placed one atop the other, in order to secure said elements to each other.

13. Component according to claim 12, **characterized in that** the oxidation layer of said at least one first element (3) and said at least one second element (4) includes siloxane connections.

14. Component according to claim 12 or 13, **characterized in that** the component includes two elements (3, 4), the first of which is pierced to receive a pivot to form the jewel hole of a bearing.

15. Component according to claim 12 or 13, **characterized in that** the component includes two elements (3, 4) which are pierced to receive an arbor and which include toothings on the outer diameter thereof to form a transmission wheel set.

16. Component according to the preceding claim, **characterized in that** said two elements (3, 4) have outer diameters of different sizes to form a reduction wheel set.

17. Timepiece **characterized in that** the timepiece incorporates a multi-level silicon component according to any of claims 12 to 16.
